(19) Europäisches Patentamt
European Patent Office
Office européen des brevets

(11) EP 3 819 348 A1

(12) **EUROPEAN PATENT APPLICATION**

(43) Date of publication:
**12.05.2021 Bulletin 2021/19**

(21) Application number: **20205290.8**

(22) Date of filing: **02.11.2020**

(51) Int Cl.:
***C09J 7/10*** *(2018.01)* ***C08K 3/08*** *(2006.01)*
***C08K 5/05*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **08.11.2019 JP 2019203292**

(71) Applicant: **Nitto Denko Corporation**
**Osaka 567-8680 (JP)**

(72) Inventors:
- **ICHIKAWA, Tomoaki**
  **Osaka, Ibaraki 567-8680 (JP)**
- **MITA, Ryota**
  **Osaka, Ibaraki 567-8680 (JP)**

(74) Representative: **Stolmár & Partner Patentanwälte PartG mbB**
**Blumenstraße 17**
**80331 München (DE)**

(54) **THERMOSETTING SHEET AND DICING DIE BONDING FILM**

(57) A thermosetting sheet according to the present invention includes, as essential components, a thermosetting resin and inorganic particles, and, as an optional component, a volatile component, in which a ratio of a packing ratio $P_2$ of the inorganic particles in the thermosetting sheet after being cured to a packing ratio $P_1$ of the inorganic particles in the thermosetting sheet before being cured is $P_2/P_1 \geq 1.3$.

Fig. 1

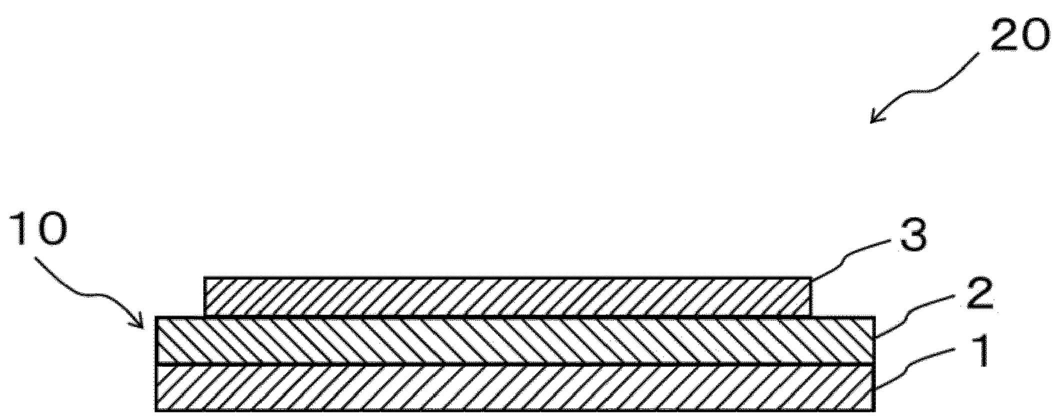


EP 3 819 348 A1

## Description

FIELD OF THE INVENTION

The present invention relates to a thermosetting sheet and a dicing die bonding film.

BACKGROUND OF THE INVENTION

There is conventionally known a method (die bonding method) for bonding a semiconductor device to an adherend such as a metal lead frame in producing a semiconductor apparatus using a thermosetting sheet (for example JP 2019-021813 A). JP 2019-021813 A discloses a thermosetting sheet including conductive particles and a thermosetting resin.
In such a method, the thermosetting sheet with its one side provided with a semiconductor device has the other side temporarily bonded to an adherend such as a metal lead frame at a specific temperature (for example 70 °C), followed by to heat curing at a higher temperature (for example 200 °C) to be thereby bonded to the adherend.
In the case where a power semiconductor device is used in a semiconductor apparatus, the power semiconductor device is used with as large power as several MVA or more, consequently generating a large amount of heat. Thus, in the case where the thermosetting sheet as above is used for a power semiconductor device, the thermosetting sheet that has been bonded to the adherend, that is, the cured thermosetting sheet, preferably has high heat dissipation.

SUMMARY OF THE INVENTION

Technical Problem

The problem of heat generation as aforementioned also occurs in the case where a semiconductor device other than a power semiconductor device is used. Nevertheless, no sufficient consideration appears to have been made on improving heat dissipation of the cured thermosetting sheet.
It is therefore an object of the present invention to provide a thermosetting sheet having a relatively high heat dissipation after being cured, and a dicing die bonding film including the thermosetting sheet.

Solution to Problem

A thermosetting sheet according to the present invention includes, as essential components, a thermosetting resin and inorganic particles, and, as an optional component, a volatile component, in which a ratio of a packing ratio $P_2$ of the inorganic particles in the thermosetting sheet after being cured to a packing ratio $P_1$ of the inorganic particles in the thermosetting sheet before being cured is $P_2/P_1 \geq 1.3$.
It is preferable that the thermosetting sheet include the volatile component as an essential component, and that the volatile component include one or more hydroxy groups and have a boiling point of 250 °C or more.
In the thermosetting sheet, it is preferable that the volatile component be a terpene compound.
In the thermosetting sheet, it is preferable that the inorganic particles be sinterable metal particles.
In the thermosetting sheet, it is preferable that the packing ratio $P_2$ of the organic particles in the thermosetting sheet after being cured be 40 volume % or more.
A dicing die bonding film according to the present invention includes: a base layer; an adhesive layer laminated on the base layer to form a dicing tape; and a thermosetting sheet laminated on the adhesive layer of the dicing tape, wherein the thermosetting sheet is any one of the thermosetting sheets above.

BRIEF DESCRIPTION OF DRAWINGS

Fig. 1 is a cross-sectional view showing a configuration of a dicing die bonding film according to one embodiment of the present invention.

DETAILED DESCRIPTION OF THE PREFERRED EMBODIMENT

Hereinafter, a description will be given on one embodiment of the present invention.

[Thermosetting sheet]

A thermosetting sheet according to this embodiment includes, as essential components, a thermosetting resin

and inorganic particles, and, as an optional component, a volatile component.

Examples of the thermosetting resin include an epoxy resin, a phenol resin, an amino resin, an unsaturated polyester resin, a polyurethane resin, a silicone resin, and a thermosetting polyimide resin. Among these, an epoxy resin is preferably used.

Examples of the epoxy resin include the epoxy resins of bisphenol A type, bisphenol F type, bisphenol S type, brominated bisphenol A type, hydrogenerated bisphenol A type, bisphenol AF type, biphenyl type, naphthalene type, fluorene type, phenol novolak type, ortho-cresol novolak type, trishydroxyphenylmethane type, tetraphenylolethane type, hydantoin type, trisglycidyl isocyanurate type, and glycidyl amine type.

Examples of the phenol resin as a curing agent for the epoxy resin include a novolak type phenol resin, a resol type phenol resin, and a polyoxystyrene such as polyparaoxystyrene.

A thermoplastic resin having a thermosetting functional group can also be used as a thermosetting resin. Examples of the thermoplastic resin having a thermosetting functional group include a thermosetting functional group-containing acrylic resin. Examples of the acrylic resin in the thermosetting functional group-containing acrylic resin include an acrylic resin including a monomer unit derived from a (meth)acrylate ester. For the thermoplastic resin having a thermosetting functional group, a curing agent is selected depending on the kind of the thermosetting functional group.

The thermosetting sheet according to this embodiment may include a thermosetting catalyst in terms of sufficiently progressing the curing reaction of the resin component or increasing the curing reaction rate. Examples of the thermosetting catalyst include an imidazole-based compound, a triphenylphosphine-based compound, an amine-based compound, and a trihalogenborane-based compound.

Examples of the volatile component can include an organic compound that includes one or more hydroxy groups and has a boiling point of 250 °C or higher. The boiling point of the organic compound is preferably 350 °C or less. Examples of such an organic compound may include a terpene compound. As the volatile component, isobornyl cyclohexanol expressed by the following formula (1) is preferable among terpene compounds. Isobornyl cyclohexanol is an organic compound with a boiling point of 308 to 318 °C, and has characteristics that, when heated under a nitrogen gas flow of 200 mL/min from room temperature (23 ± 2 °C) to 600 °C at a temperature rising rate of 10 °C/min, weight reduction becomes significant when the temperature reaches 100 °C and such significant weight reduction continues as the temperature increases, and volatilization and vanishment occurs (i.e., no further weight reduction is found) at 245 °C. Isobornyl cyclohexanol has further characteristics that it has an extremely high viscosity of 1,000,000 Pa -s at 25 °C but has a relatively low viscosity of 1000 mPa·s or less at 60 °C. The weight reduction refers to a value obtained when the weight reduction ratio at a measurement starting temperature (room temperature) is 0%. Isobornyl cyclohexanol exhibits an extremely high viscosity at 25 °C as aforementioned and thus can keep the thermosetting sheet in a sheet shape at room temperature, but at which it exhibits a relatively low viscosity at 60 °C as described above to have tackiness. That is, the thermosetting sheet including isobornyl cyclohexanol is excellent in capability of keeping itself in a sheet shape at room temperature, and has tackiness at 60 °C and higher. When a semiconductor device bonded to one side of the thermosetting sheet is mounted on a metal lead frame or the like, it is general that the semiconductor device is temporarily attached (fixed) to an adherend such as the metal lead frame via the thermosetting sheet at a temperature of 60 to 80 °C. In the case where the thermosetting sheet according to this embodiment includes, as the volatile component, isobornyl cyclohexanol, which causes tackiness at 60 °C and higher as aforementioned, the temporary bonding of the thermosetting sheet to an adherend such as a metal lead frame is more improved. That is, the thermosetting sheet in the state of being temporarily bonded suppresses the semiconductor device from being displaced from its mounting position, and is suppressed from rising from the adherend. Thus, the semiconductor device can be reliably bonded to the adherend by heat-curing the thermosetting sheet.

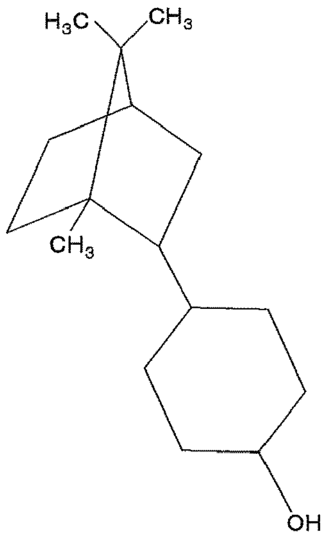

···(1)

As the inorganic particles, conductive particles and non-conductive particles can be used. The conductive particles herein refer to particles of which the electrical conductivity measured according to JIS K 0130 (2008) is 100 pS/cm or less, and the non-conductive particles herein refer to particles of which the electrical conductivity measured according to JIS K 0130 (2008) is more than 100 μS/cm.

Examples of the non-conductive particles include alumina and boron nitride. These kinds of non-conductive particles may be individually used, or two or more of them may be used in combination.

Examples of the conductive particles include nickel particles, copper particles, silver particles, aluminum particles, carbon black, carbon nanotubes, metal particles formed by plating the surface of core metal with a metal such as gold (hereinafter referred to also as plated metal particles), and resin particles coated with a metal (hereinafter referred to also as metal-coated resin particles). These kinds of conductive particles may be individually used, or two or more kinds of them may be used in combination.

As the plated metal particles, for example, particles in which nickel particles or copper particles that serve as cores are plated with a noble metal such as gold or silver can be used. As the metal-coated resin particles, for example, particles in which resin particles or the like each have a surface coated with a metal such as nickel or gold can be used.

The shape of the conductive particles may be, for example, a flake shape, a needle shape, a filament shape, a spherical shape, or a scale shape, and is preferably a spherical shape in terms of improving dispersibility and a packing ratio.

The average particle size of the inorganic particles is preferably 0.005 pm or more and 30 pm or less, more preferably 0.01 pm or more and 25 pm or less, further preferably 0.05 pm or more and 20 pm or less. The average particle size of the conductive particles can be measured using, for example, a laser diffraction and scattering type particle size distribution measuring apparatus (Microtrac MT3000II series manufactured by MicrotracBEL).

The inorganic particles are preferably sinterable metal particles. This configuration enables at least part of the sinterable metal particles included in the thermosetting sheet to be sintered after the thermosetting sheet is cured, thereby easily forming a heat dissipating path in a thickness direction of the thermosetting sheet. This enables the thermosetting sheet to have a relatively high heat dissipation. Examples of the sinterable metal particles include fine particles formed of a metal. Examples of the metal forming the fine particles include gold, silver, and copper. Among these, silver is preferably used. The sinterable particles herein refer to particles, at least a part of which come into tight contact with each other and are hence solidified when heated at a temperature equal to or lower than the melting point of the material forming the particles.

The average particle size of the sinterable metal particles is preferably 0.0005 pm or more, more preferably 0.001 pm or more. The average particle size of the sinterable metal particles is preferably 1 pm or less, more preferably 0.5 μm or less. The average particle size of the sinterable metal particles being 1 pm or less enables more sufficient sintering of the sinterable metal particles at a temperature at which a thermosetting resin is cured (for example 200 °C).

The average particle size of the sinterable metal particles can be measured by observing the sinterable metal particles using an SEM (scanning electron microscope). It is preferable that the sinterable metal particles be observed using the SEM at a magnification of 5000 times when they are of a micro size, at a magnification of 50000 times when they are of a submicron size, or at a magnification of 300000 times when they are of a nano size.

The sinterable metal particles may include aggregated nanoparticles in which sinterable metal nanoparticles are aggregated. The mass ratio of the sinterable metal particles to the total mass of the conductive metal particles is

preferably 50 mass % or more and 90 mass % or less.

In the thermosetting sheet according to this embodiment, the ratio of a packing ratio $P_2$ of the inorganic particles in the thermosetting sheet after being cured to a packing ratio $P_1$ of the inorganic particles in the thermosetting sheet before being cured is $P_2/P_1 \geq 1.3$. Such a ratio between the packing ratios can be obtained by at least one of shrinkage of the thermosetting resin as an essential component after curing (for example, shrinkage of an epoxy resin caused by curing) and volatilization of the volatile component as an optional component at the time of curing. The packing ratio $P_1$ of the inorganic particles in the thermosetting sheet before being cured and the packing ratio $P_2$ of the inorganic particles in the thermosetting sheet after being cured satisfy the abovementioned relationship to enable the cured thermosetting sheet to have a relatively high heat dissipation.

The packing ratio of the inorganic particles herein refers to a proportion of the inorganic particles occupied per unit volume. The packing ratio of the inorganic particles can be obtained by: mechanically polishing a thermosetting sheet to expose its cross section; capturing an SEM image in a given cross-sectional area of the exposed cross section using a field emission scanning electron microscope to obtain a reflected electron image as an image data; and analyzing the image data.

In the case where the thermosetting sheet according to this embodiment includes the sinterable metal particles as the inorganic particles, the inorganic particles form a continuous phase in the thermosetting sheet to achieve excellent electric conductivity and thermal conductivity.

Since the thermosetting sheet according to this embodiment includes organic components such as the thermosetting resin in addition to the inorganic particles, the thermosetting sheet has the inorganic particles and the organic components mixed therein. This configuration allows the sheet to have a relatively low elastic modulus, thereby capable of relatively relaxing the stress applied to the sheet. Consequently, damage to the sheet can be suppressed.

The thermosetting sheet according to this embodiment may include a thermoplastic resin in addition to the thermosetting resin. The thermoplastic resin functions as a binder. Examples of the thermoplastic resin includes natural rubber, a butyl rubber, an isoprene rubber, a chloroprene rubber, an ethylene-vinyl acetate copolymer, an ethylene-acrylate copolymer, an ethylene-acrylate ester copolymer, a polybutadiene resin, a polycarbonate resin, a thermoplastic polyimide resin, a polyamide resin such as polyamide 6 or polyamide 6,6, a phenoxy resin, an acrylic resin, a saturated polyester resin such as PET or PBT, a polyamide-imide resin, and a fluororesin. These kinds of thermoplastic resins may be individually used, or two or more kinds of them may be used in combination. As the thermoplastic resin, an acrylic resin is preferable in terms of its small amount of ionic impurities and high heat resistivity allowing the thermosetting sheet to easily secure connection reliability.

The acrylic resin is preferably a polymer that includes a monomer unit derived from a (meth)acrylate ester as the largest monomer unit by mass ratio. Examples of the (meth)acrylate ester include (meth)acrylate alkyl ester, (meth)acrylate cycloalkyl ester, and (meth)acrylate aryl ester. The acrylic resin may include a monomer unit derived from other component copolymerizable with the (meth)acrylate ester. Examples of the other component include a carboxy group-containing monomer, an acid anhydride monomer, a hydroxy group-containing monomer, a glycidyl group-containing monomer, a sulfonic acid group-containing monomer, a phosphate group-containing monomer, a functional group-containing monomer such as acrylic amid or acrylonitrile, and various multifunctional monomers. In terms of achieving high cohesive force in a die bonding layer, the acrylic resin is preferably a copolymer of a (meth)acrylate ester (in particular a (meth)acrylate alkyl ester having a 4C or less alkyl group), a carboxy group-containing monomer, a nitrogen atom-containing monomer, and a multifunctional monomer (in particular, a polyglycidyl-based multifunctional monomer), is more preferably a copolymer of ethyl acrylate, butyl acrylate, acrylic acid, acrylonitrile, and polyglycidyl (meth)acrylate.

The thermosetting sheet according to this embodiment may include one or more kinds of other components as needed. Examples of the other components include a filler dispersant, a flame retarder, a silane coupling agent, and an ion trapping agent.

The thermosetting sheet according to this embodiment has a thickness of preferably 5 pm or more, more preferably 10 pm or more, further preferably 20 pm or more. The thermosetting sheet has a thickness of preferably 150 pm or less, more preferably 100 pm or less, further preferably 80 pm or less. The thermosetting sheet having a thickness of 150 pm or less can have more improved heat conductivity. The thickness of the thermosetting sheet can be obtained by measuring the thickness thereof at any 5 positions selected at random using a dial gauge (model R-205 manufactured by PEACOCK), followed by arithmetically averaging these thickness values.

[Dicing die bonding film]

Next, a description will be given on a dicing die bonding film 20 with reference to Fig. 1. Hereinafter, any description that has already been given for describing the thermosetting sheet will not be repeated.

As shown in Fig. 1, the dicing die bonding film 20 according to this embodiment includes a base layer 1, an adhesive layer 2 laminated on the base layer 1 to form a dicing tape 10, and a thermosetting sheet 3 laminated on the adhesive layer 2 of the dicing tape 10. The dicing die bonding film 20 has a semiconductor device attached on the

thermosetting sheet 3. The semiconductor device may be a bare wafer. The bare wafer attached to the dicing die bonding film 20 according to this embodiment is subjected to bare chip cutting treatment by blade dicing. The thermosetting sheet 3 is also cut at the time of the cutting of the bare wafer by blade dicing. The thermosetting sheet 3 is cut into pieces each having a size corresponding to the size of each of a plurality of bare chips formed into individual pieces. The bare chips to which the thermosetting sheet 3 is attached can be thus obtained.

As aforementioned, the thermosetting sheet 3 of the dicing die bonding film 20 is a thermosetting sheet including, as the essential components, the thermosetting resin and the inorganic particles, and, as the optional component, the volatile component, in which the ratio of the packing ratio $P_2$ of the inorganic particles in the thermosetting sheet after being cured to the packing ratio $P_1$ of the inorganic particles in the thermosetting sheet before being cured is $P_2/P_1 \geq 1.3$.

The base layer 1 supports the adhesive layer 2, and the thermosetting sheet 3 laminated on the adhesive layer 2. The base layer 1 includes a resin. Examples of the resin include an olefin-based resin such as polyethylene (PE), polypropylene (PP), or ethylene-propylene copolymer; a copolymer including ethylene as a monomer component, such as ethylene-vinyl acetate copolymer (EVA), an ionomer resin, ethylene-(meth) acrylate copolymer, or ethylene-(meth)acrylate ester (random or alternate) copolymer; a polyester such as polyethylene terephthalate (PET), polyethylene naphthalene (PEN), or polybutylene terephthalate (PBT); an acrylic resin; polyvinyl chloride (PVC); polyurethane; polycarbonate; polyphenylene sulfide (PPS); an amide-based resin such as polyamide or wholly aromatic polyamide (aramid); polyether ether ketone (PEEK); polyimide; polyether imide; polyvinylidene chloride; acrylonitrile butadiene styrene copolymer (ABS); a cellulose-based resin; a silicone resin; and a fluororesin. Among these, polyethylene terephthalate is preferably included in the base layer 1.

The base layer 1 may include one kind of the aforementioned resins, or may include two or more kinds of the aforementioned resins.

A material of the base layer 1 may be a crosslinked polymer or the like of any of the resins (for example, a plastic film). The plastic film may be used without being stretched, or may be subjected to uniaxial or biaxial stretching as needed for use. According to a resin sheet to which heat shrinkability is imparted by stretching or the like, a contact area between the adhesive layer 2 and the thermosetting sheet 3 can be reduced by causing the base layer 1 of the resin sheet to heat shrink after dicing, to thereby allow the semiconductor chips (semiconductor devices) to be easily collected.

A surface of the base layer 1 may be subjected to a general surface treatment to increase, for example, its tight adhesiveness to an adjacent layer, or its capability of being secured to the adjacent layer. Examples of the surface treatment include a chemical or physical treatment such as chromic acid treatment, ozone exposure, flame exposure, high-pressure electric shock exposure, or ionized radiation treatment; and coating treatment using a primer.

The base layer 1 has a thickness of preferably 1 pm or more and 1000 pm or less, more preferably 10 pm or more and 500 pm or less, further preferably 20 pm or more and 300 pm or less, particularly preferably 30 pm or more and 200 pm or less. The thickness of the base layer 1 can be obtained using a dial gauge (model R-205 manufactured by PEACOCK), as in the thickness of the thermosetting sheet 3 as aforementioned.

The base layer 1 may include various additives. Examples of the various additives include a colorant, a filler, a plasticizer, an aging retardant, an antioxidant, a surfactant, and a flame retarder.

An adhesive used for forming the adhesive layer 2 is not particularly limited, and for example a general pressure-sensitive adhesive such as an acrylic adhesive or a rubber adhesive can be used. The pressure-sensitive adhesive is preferably an acrylic adhesive including an acrylic polymer as a base polymer in terms of, for example, securing clean washability of electronic components such as semiconductor wafers or glasses, which should be kept away from contamination, using ultrapure water or an organic solvent such as an alcohol.

Examples of the acrylic polymer include an acrylic polymer that includes, as a monomer component, one or more kinds of a (meth)acrylate alkyl ester and a (meth)acrylate cycloalkyl ester. Examples of the (meth)acrylate alkyl ester can include a linear or branched alkyl ester having a 1-30C, particularly 4-18C alkyl group, such as methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, or eicosyl ester. Examples of the (meth)acrylate cycloalkyl ester can include cyclopentyl ester and cyclohexyl ester. The (meth)acrylate ester means at least one of the acrylate ester or the methacrylate ester, and the term (meth) herein is used in the same way as above throughout the specification.

The acrylic polymer may include a unit corresponding to another monomer component that is copolymerizable with the (meth)acrylate alkyl ester or the (meth)acrylate cycloalkyl ester, as appropriate, for the purpose of improving cohesive force, heat resistance, or the like. Examples of such a monomer component include: a carboxyl group-containing monomer such as acrylate, methacrylate, carboxyethyl (meth)acrylate, carboxypentyl (meth)acrylate, itaconic acid, maleic acid, fumaric acid, or crotonic acid; an acid anhydride monomer such as maleic anhydride or itaconic anhydride; a hydroxy group-containing monomer such as 2-hydroxythyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate,

12-hydroxylauryl (meth)acrylate, or (4-hydroxymethyl cyclohexyl) methyl (meth)acrylate; a sulfonic acid group-containing monomer such as styrenesulfonic acid, arylsulfonic acid, 2-(meth)acrylamide-2-methylpropanesulfonic acid, (meth)acryloyloxynaphthalenesulfonic acid, or sulfopropyl (meth)acrylate; a phosphate group-containing monomer such as 2-hydroxyethyl acryloyl phosphate; acrylamide; and acrylonitrile. One or more kinds of these copolymerizable monomer components can be used. The amount of these copolymerizable monomers in use is preferably 40 mass % or less of the total monomer components.

The acrylic polymer can further include a multifunctional monomer or the like as a copolymerizing monomer component as needed for crosslinking. Examples of such a multifunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, tripmethylolpropane tri(meth)acrylate, pentaerythritol tri(meth)acrylate, dipentaerythritol hexa(meth)acrylate, epoxy (meth)acrylate, polyester (meth)acrylate, and urethane (meth)acrylate. One or more kinds of these multifunctional monomers can be used. The amount of these multifunctional monomers in use is preferably 30 mass % or less of the total monomer components in terms of, for example, their adhesion characteristics.

The acrylic polymer can be obtained by polymerizing a single monomer or two or more kinds of monomer mixtures. The polymerization may be performed by any of solution polymerization, emulsion polymerization, bulk polymerization, suspension polymerization, and the like. The acrylic polymer preferably has a small content of low-molecular weight substances in terms of, for example, preventing a clean adherend from contamination. In this regard, the number average molecular weight of the acrylic polymer is preferably 300,000 or more, more preferably about 400,000 to 3,000,000.

An external crosslinking agent can be appropriately added to the adhesive, in order to increase the number average molecular weight of the acrylic polymer or the like, which is the base polymer of the adhesive. Specific examples of the external crosslinking method include a method which includes adding a crosslinking agent such as a polyisocyanate compound, an epoxy compound, an aziridine compound, or a melamine-based crosslinking agent to the adhesive to cause a reaction. In the case where the external crosslinking agent is used, the amount of the external crosslinking agent in use is determined as appropriate, in consideration of the balance with the amount of the base polymer to be crosslinked and its intended use as the adhesive. Generally, the amount of the external crosslinking agent mixed with the base polymer is preferably about 5 parts by mass or less, more preferably 0.1 to 5 parts by mass based on 100 parts by mass of the base polymer.

In addition to the aforementioned components, the adhesive may include additives such as any known tackifier and aging retardant as appropriate.

The adhesive layer 2 can be formed of a radiation-curable adhesive. The radiation-curable adhesive can easily reduce its pressure-sensitive adhesiveness by being irradiated with radiation such as ultraviolet rays to increase the degree of crosslinking. That is, the adhesive layer 2 formed of the radiation-curable adhesive allows the thermosetting sheet 3 to be in sufficient contact with the adhesive layer 2 without being subjected to radiation irradiation before dicing, and reduces its pressure-sensitive adhesiveness by being subjected to radiation irradiation after dicing so that semiconductor chips (semiconductor devices) can be easily picked up or collected.

The radiation-curable adhesive is not particularly limited, and can be any adhesive as long as it has a radiation-curable functional group of a carbon-carbon double bond or the like, and exhibits pressure-sensitive adhesiveness. Examples of the radiation-curable adhesive include an additive-type radiation-curable adhesive in which a radiation-curable monomer component or oligomer component is mixed with a general pressure-sensitive adhesive such as an acrylic adhesive or a rubber adhesive.

Examples of the radiation-curable monomer component include urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, and 1,4-butanediol di(meth)acrylate. Examples of the radiation-curable oligomer component include a urethane-based oligomer, a polyether-based oligomer, a polyester-based oligomer, a polycarbonate-based oligomer, a polybutadiene-based oligomer, and various other oligomers, and any of these oligomers having a molecular weight of about 100 to 30,000 is preferable. The mixing amount of the radiation-curable monomer component or the radiation-curable oligomer component is preferably such an amount as to allow the adhesive layer 2 to appropriately reduce its pressure-sensitive adhesiveness after radiation irradiation. Generally, the mixing amount of the radiation-curable monomer component or the radiation-curable oligomer component is, for example, preferably 5 to 500 parts by mass, more preferably 40 to 150 parts by mass, based on the 100 parts by mass of the base polymer such as an acrylic polymer constituting the adhesive.

In addition to the additive-type radiation-curable adhesives mentioned above, the radiation-curable adhesive can be an intrinsic-type radiation-curable adhesive in which a polymer having a carbon-carbon double bond in a side chain or the main chain of the polymer or at a terminal of the main chain is used as the base polymer. The intrinsic-type radiation-curable adhesive does not need to include an oligomer component or the like, which is a low-molecular component, or includes a relatively small content of the oligomer component or the like. Thus, the use of the intrinsic-type radiation-curable adhesive suppresses the oligomer component or the like from migrating within the adhesive layer 2

over time. As a result, the adhesive layer 2 can have a relatively stable layer structure.

The base polymer having the carbon-carbon double bond is not particularly limited as long as it has a carbon-carbon double bond and has pressure-sensitive adhesiveness. Such a base polymer preferably has an acrylic polymer as the basic skeleton. Examples of the basic skeleton of the acrylic polymer include the aforementioned acrylic polymers.

A method for introducing the carbon-carbon double bond into the acrylic polymer is not particularly limited and various methods can be employed, but when adopting a method in which the carbon-carbon double bond is introduced in a polymer side chain, molecular design can be easily made. Examples of the method include a method in which a monomer having a functional group is in advance caused to copolymerize with the acrylic polymer, followed by subjecting a compound having the carbon-carbon double bond and a functional group that can react with the functional group of the monomer to a condensation reaction or an addition reaction in the state where the carbon-carbon double bond is kept radiation-curable.

Examples of the combination of the functional groups include: a carboxylic acid group and an epoxy group, a carboxylic acid group and an aziridinyl group, and a hydroxy group and an isocyanate group. Among these combinations of the functional groups, a combination of a hydroxy group and an isocyanate group is preferable in terms of easy reaction tracking. In these combinations of the functional groups, any of the functional groups can be present on any side of the acrylic polymer and the compound having the carbon-carbon double bond, as long as the combination of the functional groups generates an acrylic polymer having the carbon-carbon double bond. In the case of the aforementioned preferable combination, however, it is preferable that the acrylic polymer have a hydroxy group and the compound having the carbon-carbon double bond have an isocyanate group. In this case, examples of the isocyanate compound having the carbon-carbon double bond include methacryloyl isocyanate, 2-methacryloyloxyethyl isocyanate, and m-isopropenyl-α,α-dimethylbenzyl isocyanate. Examples of the acrylic polymer include a polymer formed by copolymerizing an ether-based compound or the like such as the aforementioned hydroxy group-containing monomer, 2-hydroxyethyl vinyl ether, 4-hydroxybutyl vinyl ether, or diethylene glycol monovinyl ether.

In the intrinsic-type radiation-curable adhesive, the base polymer having the carbon-carbon double bond (in particular an acrylic polymer) may be individually used, but the radiation-curable monomer component or the radiation-curable oligomer component can be added in such an amount as not to impair the characteristics of the adhesive. The radiation-curable oligomer component or the like is included generally in the range of 30 parts or less by mass, preferably in the range of 1 to 10 parts by mass, based on 100 parts by mass of the base polymer.

The radiation-curable adhesive includes a photopolymerization initiator in the case of being cured by, for example, ultraviolet rays. Examples of the photopolymerization initiator include an α-ketol-based compound such as 4-(2-hydroxyethoxy)phenyl(2-hydroxy-2-propyl) ketone, α-hydroxy-α,α'-dimethylacetophenone, 2-methyl-hydroxypropiophenone, or 1-hydroxycyclohexyl phenyl ketone; an acetophenone-based compound such as methoxyacetophenone, 2,2-dimethoxy-2-phenylacetophenone, 2,2-diethoxyacetophenone, or 2-methyl-1-[4-(methylthio)-phenyl]-2-morpholinopropane-1; an benzoin ether-based compound such as benzoin ethyl ether, benzoin isopropyl ether, or anisoin methyl ether; a ketal-based compound such as benzil dimethylketal; an aromatic sulfonyl chloride-based compound such as 2-naphthalene sulfonyl chloride; a photoactive oxime-based compound such as 1-phenone-1,1-propanedione-2-(o-ethoxycarbonyl)oxime; a benzophenone-based compound such as benzophenone, benzoyl benzoic acid, or 3,3'-dimethyl-4-metoxybenzophenone; a thioxanthone-based compound such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, or 2,4-diisopropylthioxanthone; camphorquinone; halogenated ketone; acylphosphine oxide; and acylphosphonate. The mixing amount of the photopolymerization initiator is, for example, 0.05 to 20 parts by mass based on 100 parts by mass of an acrylic polymer as the base polymer constituting the adhesive.

Examples of the radiation-curable adhesive include a rubber or acrylic adhesive disclosed in JP S60-196956 A, which includes: a photopolymerizable compound such as an addition polymerizable compound having two or more unsaturated bonds or alkoxysilane having an epoxy group; and a photopolymerization initiator such as a carbonyl compound, an organic sulfur compound, a peroxide, amine, or an onium salt-based compound.

In the case where curing inhibition by oxygen occurs at the time of radiation irradiation, it is desirable to keep the surface of the radiation-curable adhesive layer 2 away from oxygen (air) using some method. For example, the method can be performed by covering the surface of the adhesive layer 2 with a separator, or by irradiating the surface of the adhesive layer 2 with radiation such as ultraviolet rays in a nitrogen gas atmosphere.

The thickness of the adhesive layer 2 is not particularly limited, but is preferably 1 to 50 μm, more preferably 2 to 30 μm, further preferably 5 to 25 μm, in terms of both preventing chipping of a chip cutting surface and achieving the capability of enabling the thermosetting sheet 3 to be secured to the adhesive layer 2 and kept in the secured state.

The matters disclosed herein include the following:

(1) A thermosetting sheet including, as essential components, a thermosetting resin and inorganic particles, and, as an optional component, a volatile component, in which a ratio of a packing ratio $P_2$ of the inorganic particles in the thermosetting sheet after being cured to a packing ratio $P_1$ of the inorganic particles in the thermosetting sheet

before being cured is $P_2/P_1 \geq 1.3$.

According to such a configuration, at least one of shrinkage of the thermosetting resin as an essential component after curing and volatilization of the volatile component as an optional component at the time of curing causes the cured thermosetting sheet to have a relatively small volume. As a result, the ratio of the packing ratio $P_2$ of the inorganic particles in the cured thermosetting sheet to the packing ratio $P_1$ of the inorganic particles in the thermosetting sheet before being cured can be $P_2/P_1 \geq 1.3$. Consequently, the cured thermosetting sheet can have a relatively high packing ratio of the inorganic particles therein. The cured thermosetting sheet can thus have a relatively high heat dissipation.

(2) The thermosetting sheet of (1) above including the volatile component as an essential component, in which the volatile component includes one or more hydroxy groups and has a boiling point of 250 °C or more.

According to such a configuration, the thermosetting sheet further includes the volatile component, and the volatile component includes one or more hydroxy groups and has a boiling point of 250 °C or more, enabling the cured thermosetting sheet to have a higher heat dissipation.

(3) The thermosetting sheet of (1) or (2) above, in which the volatile component is a terpene compound.

According to such a configuration, the volatile component is a terpene compound, enabling the cured thermosetting sheet to have a higher heat dissipation.

(4) The thermosetting sheet of (3) above, in which the terpene compound is isobornyl cyclohexanol expressed by the following formula (1):

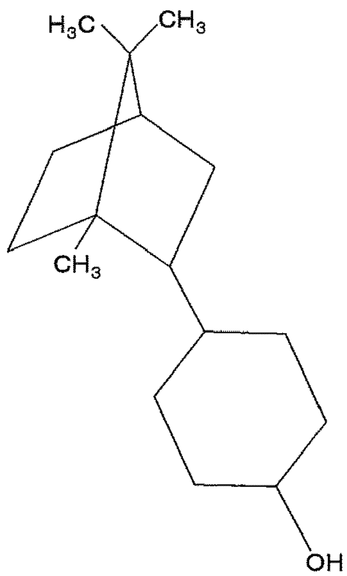

···(1)

According to such a configuration, the temporary bonding of the thermosetting sheet to an adherend such as a metal lead frame is more improved. That is, the thermosetting sheet in the state of being temporarily bonded suppresses the semiconductor device from being displaced from its mounting position, and is suppressed from rising from the adherend. Thus, the semiconductor device can be reliably bonded to the adherend by heat-curing the thermosetting sheet.

(5) The thermosetting sheet of any one of (1) to (4) above, in which the conductive particles are sinterable metal particles.

(6) The thermosetting sheet of (5) above, in which the sinterable metal particles include silver.

According to such a configuration, the conductive particles are the sinterable metal particles, enabling at least a part of the conductive particles in the cured thermosetting sheet to be sintered. As a result, a more sufficient heat dissipating path can be formed in the thickness direction of the cured thermosetting sheet. The cured thermosetting sheet can thus have a higher heat dissipation.

(7) The thermosetting sheet of any one of (1) to (6) above, in which the packing ratio $P_2$ of the organic particles in the thermosetting sheet after being cured is 40 volume % or more.

According to such a configuration, the packing ratio $P_2$ of the organic particles in the thermosetting sheet after being cured is 40 volume % or more, enabling the cured thermosetting sheet to have a higher heat dissipation.

(8) A dicing die bonding film including: a base layer; an adhesive layer laminated on the base layer to form a dicing tape; and a thermosetting sheet laminated on the adhesive layer of the dicing tape, in which the thermosetting sheet is any one of (1) to (7) above.

According to such a configuration, the dicing die bonding film can include a cured thermosetting sheet having a relatively high heat dissipation.

The thermosetting sheet and the dicing die bonding film according to the present invention are not limited to the aforementioned embodiment. The thermosetting sheet and the dicing die bonding film according to the present invention are not limited by the aforementioned operational advantages, either. Various modifications can be made for the thermosetting sheet and the dicing die bonding film according to the present invention without departing from the gist of the present invention.

EXAMPLES

Hereinafter, the present invention will be more specifically described with reference to the examples. The following examples are provided for more specifically describing the present invention, and do not intend to limit the scope of the present invention.

<Thermosetting sheet>

[Example 1]

A mixture of materials having the respective mass ratios shown in the column "Example 1" of Table 1 below was stirred using a hybrid mixer (product name: HM-500 manufactured by KEYENCE CORPORATION) for 3 minutes to prepare a varnish. The varnish was applied to one side of a release treatment film (product name: MRA38, with a thickness of 38 μm, manufactured by Mitsubishi Chemical Corporation), followed by being allowed to dry at 100 °C for 2 minutes to obtain a thermosetting sheet having a thickness of 30 μm. The materials shown in Table 1 below are as follows:

- Phenol resin
  MEHC-7851S (biphenyl type phenol resin, phenol equivalent of 209 g/eq), manufactured by MEIWA PLASTIC INDUSTRIES, LTD.
- Solid epoxy resin
  KI-3000-4 (cresol novolak type multifunctional epoxy resin, epoxy equivalent of 200 g/eq), manufactured by Nippon Steel & Sumikin Chemical Co., Ltd.
- Liquid epoxy resin
  EXA-4816 (aliphatic modified bisphenol A type epoxy resin(bifunctional type), epoxy equivalent of 403 g/eq), manufactured by DIC Corporation
- Filler dispersant
  UC-3510 (acrylic acid-based polymer (acrylic resin)), manufactured by TOAGOSEI CO., LTD.
- Silver-coated copper particles
  10% Ag/1200YP (flat copper particles (1200YP) coated with 10 mass % of silver particles, with the average particle size of 3.5 μm, irregular shapes), manufactured by MITSUI MINING & SMELTING CO., LTD.
- Silver particles
  SPH02J (aggregated Ag nanoparticles, irregular shapes, with the average particle size of aggregates of 1.8 μm), manufactured by MITSUI MINING & SMELTING CO., LTD.
- Isobornyl cyclohexanol (MTPH)
  MTPH manufactured by Nippon Terpene Chemicals, Inc.
- Acrylic resin solution
  TEISANRESIN SG-70L (including MEK and toluene as solvents, solid content of 12.5%, glass transition temperature of -13 °C, mass-average molecular weight of 900,000, acid value of 5 mg/KOH, carboxyl group-containing acrylic copolymer), manufactured by Nagase ChemteX Corporation
- Coupling agent
  KBE-846 (bis(triethoxysilylpropyl)tetrasulfide), manufactured by Shin-Etsu Chemical Co., Ltd.
- Catalyst
  TPP-K (tetraphenylphosphonium tetraphenylborate), manufactured by HOKKO CHEMICAL INDUSTRY CO., LTD.
- Solvent
  Methyl ethyl ketone

Table 2 below shows a mass ratio of the silver particles (aggregated nanoparticles) to the total mass of the metal particles (silver-coated copper particles and silver particles (aggregated nanoparticles)), and a mass ratio of isobornyl cyclohexanol to the total mass of the organic components (phenol resin, epoxy resin (solid and liquid), acrylic

resin solution, and isobornyl cyclohexanol).

[Example 2]

The thermosetting sheet according to Example 2 was obtained in the same manner as in Example 1, except that a mixture of materials having the respective mass ratios shown in the column "Example 2" of Table 1 below was used.

[Example 3]

The thermosetting sheet according to Example 3 was obtained in the same manner as in Example 1, except that a mixture of materials having the respective mass ratios shown in the column "Example 3" of Table 1 below was used.

[Example 4]

The thermosetting sheet according to Example 4 was obtained in the same manner as in Example 1, except that a mixture of materials having the respective mass ratios shown in the column "Example 4" of Table 1 below was used.

[Comparative Example 1]

The thermosetting sheet according to Comparative Example 1 was obtained in the same manner as in Example 1, except that a mixture of materials having the respective mass ratios shown in the column "Comparative Example 1" of Table 1 below was used.

Table 1

| | Unit | Ex. 1 | Ex. 2 | Ex. 3 | Ex. 4 | C. Ex. 1 |
|---|---|---|---|---|---|---|
| Phenol resin | Parts by mass | 1.00 | 0.55 | 0.55 | 1.18 | 1.66 |
| Solid epoxy resin | Parts by mass | 0.49 | 0.26 | 0.26 | 0.56 | 0.8 |
| Liquid epoxy resin | Parts by mass | 1.00 | 0.55 | 0.55 | 1.18 | 1.65 |
| Filler dispersant | Parts by mass | 0.16 | 0.09 | 0.09 | 0.19 | 0.16 |
| Silver-coated copper particles | Parts by mass | 6.62 | 7.39 | 2.46 | 2.71 | 6.70 |
| Silver particles | Parts by mass | 15.46 | 17.24 | 22.17 | 24.35 | 15.63 |
| Isobornyl cyclohexanol (MTPH) | Parts by mass | 5.00 | 2.73 | 2.70 | 1.56 | 0 |
| Acrylic resin solution | Parts by mass | 5.00 | 2.73 | 2.73 | 5.84 | 8.24 |
| Coupling agent | Parts by mass | 0.14 | 0.08 | 0.08 | 0.17 | 0.14 |
| Catalyst | Parts by mass | 0.003 | 0.002 | 0.002 | 0.004 | 0.005 |
| Methyl ethyl ketone (MEK, solvent) | Parts by mass | 13.1 | 13.1 | 13.1 | 19.6 | 13.1 |

<Packing ratio of metal particles>

A thermosetting sheet before being cured was mechanically polished to expose its cross section, and the exposed cross section was subjected to ion polishing using an ion polisher (product name: Cross Section Polisher SM-09010 manufactured by JEOL, Ltd.). Then, an SEM image (an image obtained by a scanning electron microscope) of a given cross-sectional area of the exposed cross section that had been ion-polished was captured using a field emission scanning electron microscope SU8020 (manufactured by Hitachi High-Tech Corporation) at an accelerating voltage of 5 kV and at a magnification of 5000 times to obtain a reflected electron image as an image data. Next, the obtained image data was subjected to automatic binarization processing, in which the data was binarized into a metal portion and a resin portion using image analysis software ImageJ. The total area of the metal portion and the entire (metal portion + resin portion) area were obtained from the binarized image, and the total area of the metal portion was divided by the entire area to obtain a packing ratio $P_1$ of the metal particles in the thermosetting sheet before being cured. The packing ratio $P_1$ of the metal particles was obtained by arithmetically averaging the packing ratios obtained for five cross-sectional areas in the exposed cross-sectional area that had been ion-polished. The packing ratio $P_2$ of the metal particles in the thermosetting sheet after being cured was also obtained in a manner similar to the above.

<Thermal conductivity of thermosetting sheet>

The thermosetting sheet according to each of the Examples and Comparative Examples was heat-cured using a pressure cooker apparatus under 0.5 MPa pressure at 200 °C for an hour. The thermal conductivity for the heat-cured thermosetting sheet according to each of the Examples and Comparative Examples was calculated using the equation below:

$$\text{Thermal conductivity (W/m}\cdot\text{K)} = \text{Thermal diffusivity (m}^2\text{/s)} \times \text{Specific heat (J/g}\cdot{}^\circ\text{C)} \times \text{Specific weight (g/cm}^3\text{)}$$

The thermal diffusivity $\alpha$ ($m^2/s$) was measured by the TWA method (temperature wave analysis, measuring instrument: ai-Phase Mobile manufactured by ai-Phase Co., Ltd.). The specific heat Cp (J/g·°C) was measured by the DSC method. In the specific heat measurement, DSC6220 manufactured by SII NanoTechnology Inc. was used at a temperature rising rate of 10 °C/min and in a temperature range of 20 to 300 °C to obtain the data, based on which the specific heat was calculated according to the method stipulated in the JIS handbook (Testing Methods for Specific Heat Capacity of Plastics: K-7123). Specific weight was measured by the Archimedes method. The calculated thermal diffusivity for the cured thermosetting sheet according to each of the Examples and Comparative Examples is shown in Table 2 below.

Table 2

| | Unit | Ex. 1 | Ex. 2 | Ex. 3 | Ex. 4 | C. Ex. 1 |
|---|---|---|---|---|---|---|
| Ratio of aggregated nanoparticles in metal particles | mass % | 70 | 70 | 90 | 90 | 0 |
| Ratio of isobornyl cyclohexanol | mass % | 61.6 | 61.6 | 61.4 | 30 | 0 |
| Packing ratio P2 of metal particles after curing | volume % | 46.4 | 64.3 | 64.3 | 48.8 | 33.4 |
| Packing ratio P1 of metal particles before curing | volume % | 22.0 | 36.6 | 36.0 | 35.0 | 33.4 |
| Ratio between packing ratios P2/P1 | | 2.11 | 1.76 | 1.79 | 1.39 | 1.00 |
| Thermal conductivity of cured thermosetting sheet | W/(mK) | 4.29 | 18.34 | 17.73 | 9.75 | 1.11 |

It is understood from Table 2 that the ratios between the packing ratios $P_2/P_1$ of the thermosetting sheets according to the Examples had 1.3 or more. It is also understood from Table 2 that the thermal conductivities of the thermosetting sheets (after curing) according to the Examples had relatively high values (Example 1: 4.29 W/(m·K), Example 2: 18.34 W/(m·K), Example 3: 17.73 W/(m·K), Example 4: 9.75 W/(m·K)). In contrast, the thermal conductivity of the thermosetting sheet (after curing) according to Comparative Example had a relatively low value of 1.11 W/(m·K).

It is understood from these results that a thermosetting sheet having a ratio between packing ratios $P_2/P_1$ that falls within a specific value range can have a relatively high thermal conductivity, that is, can have an improved heat dissipation.

In the thermosetting sheets according to the Examples, the packing ratios $P_2$ of the metal particles after curing were 40 volume % or more, while in the thermosetting sheet according to Comparative Example 1, the packing ratio $P_2$ of the metal particles after curing was 33.4 volume %, which was below 40 volume %. It is understood from these results that the thermosetting sheet in which the packing ratio $P_2$ of the metal particles after curing was 40 volume % or more can have an improved heat dissipation.

REFERENCE SIGNS LIST

1: Base layer
2: Adhesive layer
3: Thermosetting sheet
10: Dicing tape
20: Dicing die bonding film

## Claims

1. A thermosetting sheet comprising, as essential components, a thermosetting resin and inorganic particles, and, as an optional component, a volatile component, wherein
a ratio of a packing ratio $P_2$ of the inorganic particles in the thermosetting sheet after being cured to a packing ratio $P_1$ of the inorganic particles in the thermosetting sheet before being cured is $P_2/P_1 \geq 1.3$.

2. The thermosetting sheet according to claim 1, comprising the volatile component as an essential component, wherein the volatile component comprises one or more hydroxy groups and has a boiling point of 250 °C or more.

3. The thermosetting sheet according to claim 1 or 2, wherein
the volatile component is a terpene compound.

4. The thermosetting sheet according to any one of claims 1 to 3, wherein
the inorganic particles are sinterable metal particles.

5. The thermosetting sheet according to any one of claims 1 to 4, wherein
the packing ratio $P_2$ of the organic particles in the thermosetting sheet after being cured is 40 volume % or more.

6. A dicing die bonding film comprising:

   a base layer;
   an adhesive layer laminated on the base layer to form a dicing tape; and
   a thermosetting sheet laminated on the adhesive layer of the dicing tape, wherein
   the thermosetting sheet is according to any one of claims 1 to 5.

Fig. 1

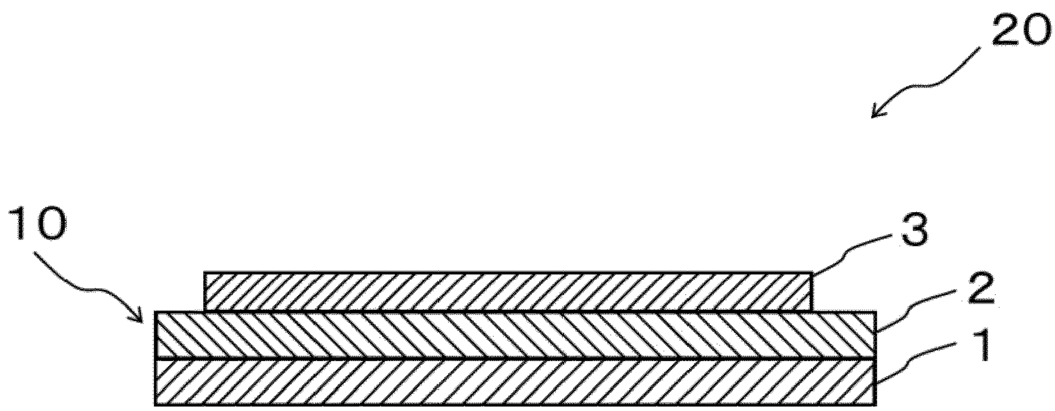

Europäisches Patentamt
European Patent Office
Office européen des brevets

# EUROPEAN SEARCH REPORT

Application Number
EP 20 20 5290

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | JP 2016 054098 A (HITACHI CHEMICAL CO LTD) 14 April 2016 (2016-04-14)<br>* paragraphs [0003], [0021], [0038] *<br>* paragraphs [0064], [0071]; examples 1,8 * | 1-5<br>6 | INV.<br>C09J7/10<br>C08K3/08<br>C08K5/05 |
| X<br>A | JP 2017 031227 A (HITACHI CHEMICAL CO LTD) 9 February 2017 (2017-02-09)<br>* paragraphs [0002], [0044], [0052], [0065], [0066]; examples 1,2 * | 1-5<br>6 | |
| X<br>Y | EP 2 770 032 A2 (NITTO DENKO CORP [JP]) 27 August 2014 (2014-08-27)<br>* paragraphs [0008], [0009], [0031], [0038], [0039], [0092], [0112]; tables 1,2 * | 1,4-6<br>1-6 | |
| X<br>Y | US 2014/120356 A1 (SHEARER CATHERINE [US] ET AL) 1 May 2014 (2014-05-01)<br>* paragraphs [0013], [0017], [0061], [0066], [0081], [0086] - [0088] * | 1,4,5<br>1-6 | TECHNICAL FIELDS SEARCHED (IPC) |
| Y | WO 2018/179796 A1 (NITTO DENKO CORP [JP]) 4 October 2018 (2018-10-04)<br>* paragraphs [0001], [0029], [0036], [0075] *<br>* examples 1,2 * | 1-6 | C09J<br>C08K<br>H01L |
| Y | US 2019/206825 A1 (SUGO YUKI [JP] ET AL) 4 July 2019 (2019-07-04)<br>* paragraphs [0008], [0071], [0129] *<br>* example 3 * | 1-6 | |

1

The present search report has been drawn up for all claims

| Place of search | Date of completion of the search | Examiner |
|---|---|---|
| Munich | 15 March 2021 | Alevizopoulou, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO. EP 20 20 5290

This annex lists the patent family members relating to the patent documents cited in the above-mentioned European search report. The members are as contained in the European Patent Office EDP file on
The European Patent Office is in no way liable for these particulars which are merely given for the purpose of information.

15-03-2021

| Patent document cited in search report | Publication date | Patent family member(s) | Publication date |
|---|---|---|---|
| JP 2016054098 A | 14-04-2016 | JP 6380792 B2 | 29-08-2018 |
| | | JP 2016054098 A | 14-04-2016 |
| JP 2017031227 A | 09-02-2017 | JP 2017031227 A | 09-02-2017 |
| | | TW 201529772 A | 01-08-2015 |
| | | WO 2015087971 A1 | 18-06-2015 |
| EP 2770032 A2 | 27-08-2014 | CN 103992755 A | 20-08-2014 |
| | | EP 2770032 A2 | 27-08-2014 |
| | | JP 6542504 B2 | 10-07-2019 |
| | | JP 2014187353 A | 02-10-2014 |
| | | KR 20140104346 A | 28-08-2014 |
| | | TW 201437311 A | 01-10-2014 |
| | | US 2014231983 A1 | 21-08-2014 |
| US 2014120356 A1 | 01-05-2014 | NONE | |
| WO 2018179796 A1 | 04-10-2018 | CN 110476233 A | 19-11-2019 |
| | | EP 3608947 A1 | 12-02-2020 |
| | | JP WO2018179796 A1 | 14-05-2020 |
| | | KR 20190130152 A | 21-11-2019 |
| | | TW 201900802 A | 01-01-2019 |
| | | US 2020048504 A1 | 13-02-2020 |
| | | WO 2018179796 A1 | 04-10-2018 |
| US 2019206825 A1 | 04-07-2019 | CN 109819657 A | 28-05-2019 |
| | | EP 3517586 A1 | 31-07-2019 |
| | | JP 2018049932 A | 29-03-2018 |
| | | TW 201813741 A | 16-04-2018 |
| | | US 2019206825 A1 | 04-07-2019 |
| | | WO 2018055889 A1 | 29-03-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2019021813 A
- JP S60196956 A